# EUROPEAN PATENT APPLICATION

(11) **EP 3 703 107 A1**
(43) Date of publication of application: **02.09.2020**
(21) Application number: 18871100.6
(22) Date of filing: 16.10.2018
(51) Int. Cl.: H01L 21/301, B28D 5/00

(54) **METHOD FOR SEGMENTING SUBSTRATE HAVING METAL FILM**

(30) Priority: 27.10.2017 JP 2017207765
(71) Applicant: Mitsuboshi Diamond Industrial Co., Ltd., Settsu, Osaka 566-0034 (JP)
(72) Inventor: MURAKAMI Kenji, Settsu City Osaka 566-0034 (JP)
(74) Representative: TBK
(86) International application number: PCT/JP2018/038406
(87) International publication number: WO 2019/082724

(57) **Abstract**

Provided is a method capable of preferably segmenting a substrate with a metal film. A method of segmenting a substrate with a metal film includes steps of: scribing a predetermined segment position in a first main surface on which a metal film is provided to form a scribe line and segmenting the metal film, and extending a vertical crack along the predetermined segment position toward an inner side of the substrate; and making a breaking bar have direct contact with the substrate with the metal film from a side of a second main surface on which the metal film is not provided to further extend the vertical crack, thereby segmenting the substrate with the metal film in the predetermined segment position.

## Description

### Technical Field

The present invention relates to a segmentation of a semiconductor device substrate, and particularly to a segmentation of substrate in which a device pattern is formed on one main surface and a metal film is formed on the other main surface.

### Background Art

For example, already known as a method of segmenting a semiconductor device substrate such as a silicon carbide (SiC) substrate is a method of performing a scribe process of forming a scribe line on one main surface of a semiconductor device substrate and extending a vertical crack from the scribe line, and subsequently performing a break process of further extending the crack in a thickness direction of the substrate by application of external force, thereby breaking the semiconductor device substrate (for example, refer to Patent Document 1).

The scribe line is formed by pressingly rotating and moving a scribing wheel (cutter wheel) along a predetermined segment position.

The break is performed by making an edge of a breaking blade (a breaking bar) have direct contact with the semiconductor device substrate along the predetermined segment position on the other main surface side of the semiconductor device substrate and further pressing the edge thereof.

The formation of the scribe line and the break are performed in a state where a dicing tape having an adhesion property is attached to the other main surface, and segmented surfaces facing each other are separated by an expansion process of stretching the dicing tape after the break process.

Known as a form of segmenting the semiconductor device substrate is a method of segmenting (singulating) a mother substrate, in which a device pattern formed of a unit pattern of a semiconductor device including a semiconductor layer and an electrode two-dimensionally repeated is formed on one main surface and a metal film is formed on the other main surface, into individual device units.

When such a division is performed by the conventional method disclosed in Patent Document 1, there is a case where the metal film is not completely segmented but remains connected in a position where the metal film should be segmented after the break process, as it were, a thin skin remains in some cases.

Even when such a thin skinned portion remains, the portion in the metal film may be segmented (fractured) in the subsequent expansion process, however, there is a problem that the metal film is easily peeled from a segmented position even if the metal film is segmented.

The present invention therefore has been made to solve the above problems, and it is an object to provide a method capable of preferably segmenting a substrate with a metal film.

### Prior Art Documents

### Patent Documents

[Patent Document 1] Japanese Patent Application Laid-Open No. 2012-146879

### Summary

In order to solve the above problems, a first aspect of the present invention is a method of segmenting a substrate with a metal film includes: a scribe step of scribing a predetermined segment position of a substrate with a metal film in a first main surface of the substrate on which a metal film is provided using a scribing tool to form a scribe line, thereby segmenting the metal film and extending a vertical crack from the scribe line along the predetermined segment position toward an inner side of the substrate with the metal film; and a break step of making a breaking bar have direct contact with the substrate with the metal film from a side of a second main surface, on which the metal film is not provided, of the substrate with the metal film to further extend the vertical crack, thereby segmenting the substrate with the metal film in the predetermined segment position.

A second aspect of the present invention is the method of segmenting the substrate with the metal film according to the first aspect, wherein the break step is performed in a state where the substrate with the metal film is in a vertically reverse posture from a case of the scribe step.

A third aspect of the present invention is the method of segmenting the substrate with the metal film according to the first or second aspect, wherein the scribe step is performed in a scribe device, the scribe device including: a stage on which an object to be scribed is disposed; and the scribing tool scribing the object to be scribed, which is disposed on the stage, from above, and in the scribe step, the substrate with the metal film is fixed to a stage in a posture where the first main surface faces the scribing tool.

A fourth aspect of the present invention is the method of segmenting the substrate with the metal film according to the third aspect, wherein the scribe device further includes a camera disposed below the stage to observe and take an image of the object to be scribed disposed on the stage, and at least a region in the stage where the camera takes an image is made of a transparent material.

According to the first to fourth aspects of the present invention, the substrate with the metal film can be preferably segmented without the occurrence of the peeling of the metal film.

### Brief Description of Drawings

[Fig. 1] A side view schematically illustrating a configuration of a substrate (a mother substrate) 10 which is to be segmented in a method according to an embodiment.
[Fig. 2] A drawing schematically illustrating a state before a scribe process is performed.
[Fig. 3] A drawing schematically illustrating a state during the scribe process.
[Fig. 4] A captured image of the substrate 10 from a metal film 3 side after the scribe process.
[Fig. 5] A drawing schematically illustrating a state before a break process is performed.
[Fig. 6] A drawing schematically illustrating a state during the break process.
[Fig. 7] A drawing schematically illustrating the substrate 10 after a second break process is performed.
[Fig. 8] A captured image indicating a state of the substrate 10 on which a conventional segmenting process has been performed.
[Fig. 9] A captured image indicating a state of the substrate 10 on which a conventional segmenting process has been performed.
[Fig. 10] A captured image of a surface of a metal film 3 on a plurality of pieces obtained by segmenting the substrate 10 at a plurality of positions by a method according to the embodiment.

### Description of Embodiment(s)

### <Semiconductor device substrate>

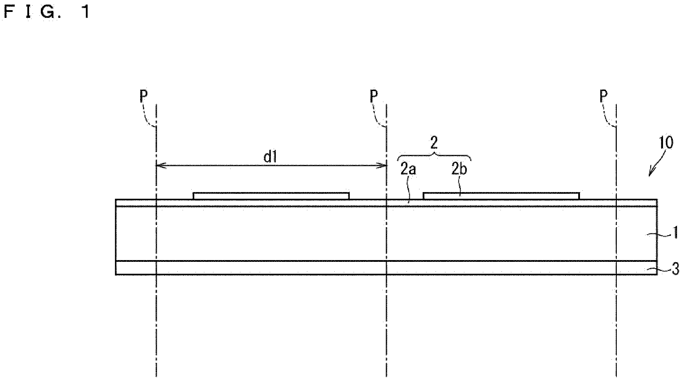

Fig. 1 is a side view schematically illustrating a configuration of a substrate (a mother substrate) 10 which is to be segmented in a method according to the present embodiment. The substrate 10 is a semiconductor device substrate segmented into pieces, each of which is to form a semiconductor device. In the present embodiment, the substrate 10 includes a base material 1, a device pattern 2 formed on one main surface of the base material 1 to have a unit pattern of a semiconductor device including a semiconductor layer and an electrode two-dimensionally repeated, and a metal film 3 formed on the other main surface of the base material 1. In other words, the substrate 10 is considered a substrate with a metal film.

The substrate 1 is a single crystal substrate made of SiC or Si or a polycrystalline substrate made of ceramic, for example. A material, a thickness, and a plane size thereof are appropriately selected and set in accordance with a type, a purpose of use, and a function of a semiconductor device to be manufactured, for example. Examples of the base material 1 include an SiC substrate having a thickness of approximately 100 to 600 µm and a diameter of 2 to 6 inches, for example.

The device pattern 2 is a part mainly relating to a development of a function and characteristics in a semiconductor device to be manufactured and including a semiconductor layer, an insulating layer, and an electrode, for example. A specific configuration is varied in accordance with a type of a semiconductor device, however, assumed in the present embodiment is a case where the device pattern 2 is made up of a thin film layer 2a formed on a whole one main surface of the base material 1 and an electrode 2b partially formed on an upper surface of the thin film layer 2a. Herein, the thin film layer 2a may be made up of a single layer or multilayer, and also the electrode 2b may be a single-layered electrode or a multilayered electrode. Also applicable is a configuration that the base material 1 is partially exposed instead of a configuration that the thin film layer 2a covers a whole surface of the base material 1. Alternatively, a plurality of electrodes 2b may be provided on one unit pattern.

A material and a size of the thin film layer 2a and the electrode 2b are appropriately selected and set in accordance with a type, a purpose of use, and a function of a semiconductor device to be manufactured, for example. For example, examples of the material of the thin film layer 2a include nitride (for example, GaN and AlN), oxide (for example, Al₂O₃, SiO₂), an intermetallic compound (for example, GaAs), and an organic compound (for example, polyimide), for example. The material of the electrode 2b may be appropriately selected from a general electrode material. For example, examples of the material of the electrode 2b include metal such as Ti, Ni, Al, Cu, Ag, Pd, Au, and Pt and an alloy thereof. A thickness of each of the thin film layer 2a and the electrode 2b is smaller than that of the base material 1.

The metal film 3 is assumed to be used mainly as a back surface electrode. However, in the method according to the present embodiment, the metal film 3 is formed on the other whole main surface of the base material 1 (more specifically, over at least the predetermined segment position). Also the metal film 3 may be a single-layered film or a multilayered film in the manner similar to the electrode 2b, and a material thereof may also be appropriately selected from a general electrode material such as metal of Ti, Ni, Al, Cu, Ag, Pd, Au, and Pt and an alloy thereof. A thickness of the metal film 3 may be normally smaller than that of the base material 1.

In the present embodiment, the substrate 10 having the above configuration is segmented in the thickness direction in a predetermined segment position P at a predetermined interval in a predetermined direction at least in a plane. The predetermined segment position P is considered as a virtual surface along the thickness direction of the substrate 10. Additionally, the predetermined segment position may be determined at an appropriate interval also in a direction perpendicular to the direction described above to obtain a semiconductor device having a rectangular shape in a plan view.

Fig. 1 illustrates the three predetermined segment positions P, which are separated from each other at an interval (pitch) d1 in a right-left direction when seeing the drawing, as alternate long and short dash lines extending beyond the substrate 10, however, the greater number of predetermined segment positions P may be actually defined in one direction. d1 is approximately 1.5 mm to 5 mm, for example, and is at least equal to or larger than 0.5 mm.

### <Scribe process>

Sequentially described hereinafter is a specific content of a segmenting process performed on the substrate 10 in the segmenting method according to the present embodiment. Firstly, the scribe process is performed on the substrate 10.

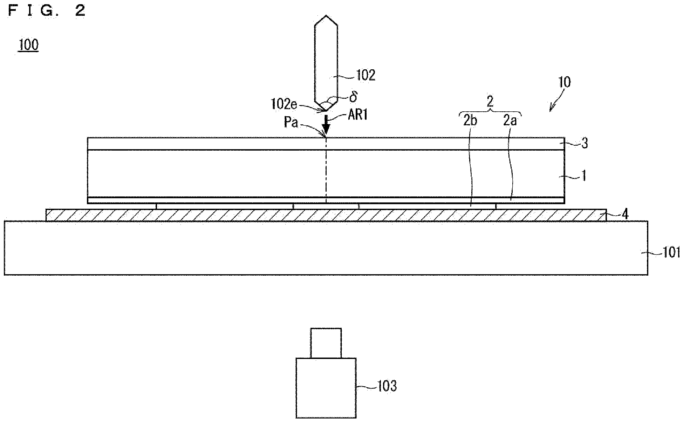

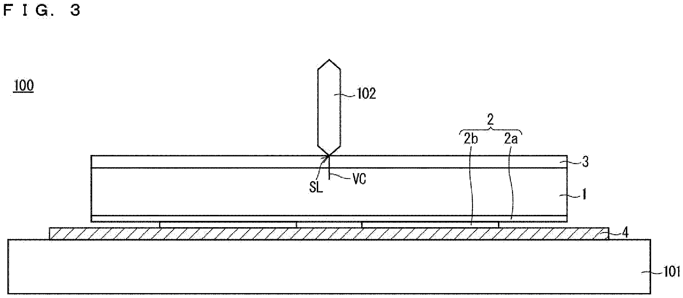

Fig. 2 is a drawing schematically illustrating a state before the scribe process is performed. Fig. 3 is a drawing schematically illustrating a state during the scribe process.

In the present embodiment, the scribe process is performed using a scribe device 100. The scribe device 100 includes a stage 101 on which an object to be scribed is disposed, a scribing wheel 102 scribing the object to be scribed from above, and a camera 103 for observing and taking an image of the object to be scribed disposed on the stage 101.

The stage 101 has a horizontal upper surface as a mounted surface, and is configured to be capable of suction-fixing the object to be scribed disposed on the mounted surface using a suction means not shown in the drawings. In the stage 101, at least a region where the camera 103 takes an image is made of a transparent material such as glass so that the camera 103 disposed below the stage 101 can observe and take the image of the object to be scribed disposed on the mounted surface. This is because the substrate 10 needs to be positioned using a shape of the device pattern 2. The stage 101 can perform a biaxial movement operation and a rotational operation in a horizontal plane using a drive mechanism not shown in the drawings.

In the meanwhile, the scribing wheel 102 is a disk-shaped member (a scribing tool) having a diameter of 2 mm to 3 mm with an edge 102e having an isosceles triangle shape in a cross-sectional view. At least the edge 102e is formed of diamond. An angle (a knife angle) 8 of the edge 102e is 100° to 150°, and is preferably 100° to 130° (for example, 110°). The scribing wheel 102 is rotatably held by a holding means, not shown in the drawings, provided to be able to go up and down in a vertical direction over the stage 101 in a vertical plane parallel to one horizontal movement direction of the stage 101.

The camera 103 is provided below the stage 101 to be able to observe and take the image on a vertically upper side. The camera 103 is a CCD camera, for example.

A known device can be applied to the scribe device 100 as long as it includes the function described above.

The scribe process is performed after a dicing tape (an expansion tape) 4 having an adhesion property and a plane size larger than a plane size of the substrate 10 is attached to a device pattern 2 side of the substrate 10 as illustrated in Fig. 2. The substrate 10 to which the dicing tape 4 is attached is simply referred to as the substrate 10 in some cases in the description hereinafter. A known dicing tape having a thickness of approximately 80 µm to 150 µm (for example, 100 µm) can be applied to the dicing tape 4.

Specifically, as illustrated in Fig. 2, the substrate 10 is firstly disposed on the stage 101 so that the dicing tape 4 comes in contact with the mounted surface of the stage 101, and is suction-fixed. That is to say, the substrate 10 is disposed and fixed to the stage 101 in a posture where a metal film 3 side is directed upward. At this time, the scribing wheel 102 is located at a height not having contact with the substrate 10.

The substrate 10 is in a vertically reverse posture from the substrate in the scribe process for segmenting the substrate with the metal film which has been conventionally and generally performed. That is to say, in the present embodiment, the substrate 10 is scribed from the metal film 3 side as described hereinafter. The surface opposite to that in the case of the scribe process for segmenting the substrate with the metal film, which has been conventionally and generally performed, is scribed in the present embodiment.

After the substrate 10 is fixed, the stage 101 is appropriately operated, thus a positioning is performed so that the predetermined segment position P and a rotational surface of the scribing wheel 102 are located in the same vertical plane. The positioning is performed to position the edge 102e of the scribing wheel 102 over a metal film end portion Pa of the predetermined segment position P as illustrated in Fig. 2. More specifically, the metal film end portion Pa of the predetermined segment position P has a straight line shape, and the positioning is performed to position the scribing wheel 102 over one end portion of the metal film end portion Pa.

When the positioning is performed, the scribing wheel 102 is moved down to a vertically lower side until the edge 102e is pressingly contacted by the metal film end portion Pa of the predetermined segment position P by the holding means not shown in the drawings as indicated by an arrow AR1 in Fig. 2.

A load (a scribe load) applied from the edge 102e to the substrate 10 in the pressing contact and a movement speed (a scribe speed) of the stage 101 may be appropriately defined in accordance with a material and thickness, for example, of a constituent material of the substrate 10, especially of the base material 1. For example, when the base material 1 is made of SiC, the scribe load needs to be approximately IN to 10N (for example, 3.5N), and the scribe speed needs to be 100 mm/s to 300 mm/s (for example, 100 mm/s).

When the pressing contact is performed, the scribing wheel 102 is moved in an extension direction (a direction vertical to the drawing in Fig. 2) of the metal film end portion Pa of the predetermined segment position P while the pressing contact is maintained. Accordingly, the scribing wheel 102 is relatively rotated and moved in the direction described above (toward the other end portion of the metal film end portion Pa).

When the pressing contact, rotation, and movement of the scribing wheel 102 proceeds along the metal film end portion Pa in the above manner, a scribe line SL is formed while the metal film 3 in the substrate 10 is segmented as illustrated in Fig. 3, and a vertical crack VC extends from the device pattern 2 to the base material 1 on the vertically lower side from the scribe line SL along the predetermined segment position P. The vertical crack VC preferably extends at least to a middle of the base material 1 from a viewpoint of a preferable division finally.

The division of the metal film 3 and the formation of the vertical crack VC are performed in all of the predetermined segment positions P by the scribe process.

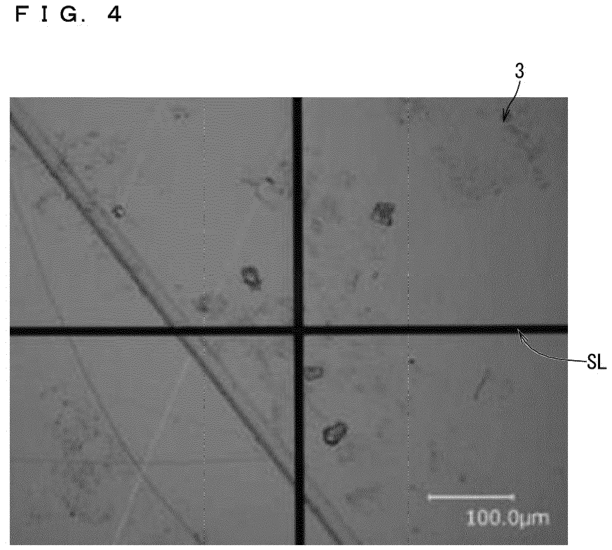

Fig. 4 is a captured image of the substrate 10 from the metal film 3 side after the scribe process. It is confirmed in Fig. 4 that the metal film 3 is preferably segmented by forming the scribe line SL and the peeling of the metal film 3 does not occur.

### <Break process>

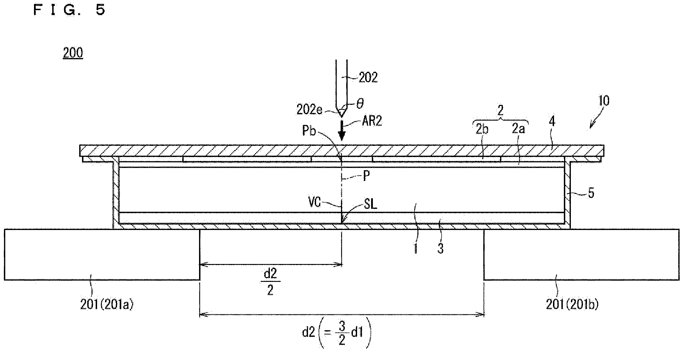

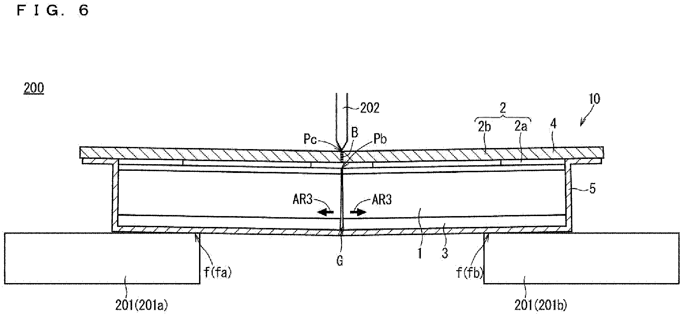

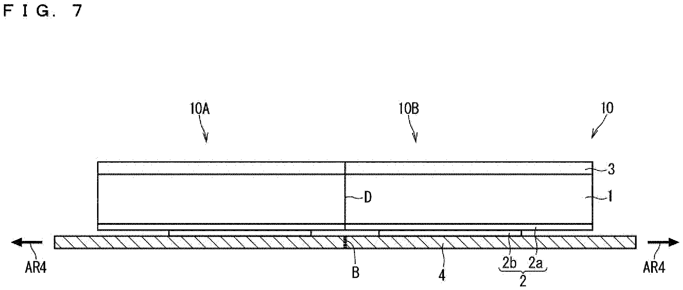

A break process is subsequently performed on the substrate 10 in which the vertical crack VC is formed as described above. Fig. 5 is a drawing schematically illustrating a state before the break process is performed. Fig. 6 is a drawing schematically illustrating a state during the break process. Fig. 7 is a drawing schematically illustrating the substrate 10 after the break process is performed.

In the present embodiment, the break process is performed using a break device 200. The break device 200 includes a holding part 201 on which an object to be broken is disposed and a breaking bar 202 performing the break process.

The holding part 201 is made up of a pair of unit holding parts 201a and 201b. The unit holding parts 201a and 201b are provided to be separated from each other with a predetermined distance (remote distance) d2 in a horizontal direction, and horizontal upper surfaces thereof having the same height position are used as mounted surfaces on which the object to be broken is disposed as a whole. In other words, the object to be broken is disposed on the holding part 201 in a state of being partially exposed to a lower side. The holding part 201 is made of metal, for example.

The holding part 201 enables an operation of moving the pair of unit holding parts 201a and 201b close to and away from each other in a predetermined direction (a back-and-forth direction of the holding part) in a horizontal plane. That is to say, the remote distance d2 can be changed in the break device 200. In Fig. 5, the right-left direction when seeing the drawing is the back-and-forth direction of the holding part.

Furthermore, the holding part 201 enables an alignment operation on the object to be broken disposed on the mounted surface in the horizontal plane using a drive mechanism not shown in the drawings.

The breaking bar 202 is a plate-like member made of metal (for example, super hard alloy) with an edge 202e having an isosceles triangle shape in a cross-sectional view extending in a blade direction. Fig. 5 illustrates the breaking bar 202 so that the blade direction is directed to be vertical to the drawing. An angle (a knife angle) θ of the edge 202e is preferably 5° to 90° (for example, 60°).

More specifically, a foremost end portion of the edge 202e has a minute curved surface having a curvature radius of approximately 5 µm to 100 µm (for example, 100 µm).

The breaking bar 202 is provided to be able to go up and down in a vertical direction in a vertical plane vertical to the back-and forth direction of the holding part by a holding means not shown in the drawings over a middle position between (an equivalent position from) the pair of unit holding parts 201a and 201b in the back-and-forth direction of the holding part.

The break process using the break device 200 having the configuration described above is performed, as illustrated in Fig. 5, in a state where a protection film 5 is attached to a surface on the metal film 3 side and a side surface of the substrate 10 with the dicing tape 4, on which the scribe process has been performed. Also the substrate 10 to which the protection film 5 is attached is simply referred to as the substrate 10 in some cases in the description hereinafter. A known protection film having a thickness of approximately 10 µm to 75 µm (for example, 25 µm) can be applied to the protection film 5.

Specifically, as illustrated in Fig. 5, the substrate 10 is firstly disposed on the holding part 201 so that protection film 5 comes in contact with the mounted surface of the holding part 201. That is to say, the substrate 10 is disposed on the holding part 201 in a posture where the metal film 3 side is directed downward and the device pattern 2 side is directed upward, that is a vertically reverse posture from the case of the scribe process. At this time, the breaking bar 202 is located at a height not having contact with the substrate 10.

The substrate 10 is in a vertically reverse posture from the substrate in the break process for segmenting the substrate with the metal film which has been conventionally and generally performed, in the manner similar to the case of the scribe process. That is to say, in the present embodiment, the break process is performed on the substrate 10 from the device pattern 2 side as described hereinafter. The break process is performed on the surface opposite to that in the case of the break process for segmenting the substrate with the metal film, which has been conventionally and generally performed, in the present embodiment.

When the plurality of the predetermined segment positions P are defined at the predetermined interval (pitch) d1 as is the case for the present embodiment, the substrate 10 is disposed on the holding part 201 in a state where the pair of unit holding parts 201a and 201b are located in a manner that a relation between the remote distance d2 and the interval (pitch) d1 of the predetermined segment position P in the substrate 10 is expressed by d2 = 1.5d1 (d2 is 3/2 times the value of d1). This condition is similar to that adopted in the general break process. In the actual process, d2 needs to be within a range satisfying d2 = 1.0d1 to 1.75d1.

After the substrate 10 is disposed, the drive mechanism is appropriately operated to position the substrate 10. Specifically, the extension direction of the predetermined segment position P of the substrate 10 in which the scribe line SL and furthermore, the vertical crack VC is provided in the scribe process is made to coincide with the blade direction of the breaking bar 202. The positioning is performed to position the edge 202e of the breaking bar 202 over a device pattern end portion Pb of the predetermined segment position P as illustrated in Fig. 6.

When the positioning is performed, the breaking bar 202 is moved down to a vertically lower side so that the edge 202e is directed toward the device pattern end portion Pb of the predetermined segment position P as indicated by an arrow AR2 in Fig. 5.

At this time, the edge 202e of the breaking bar 202 does not have direct contact with the device pattern end portion Pb of the predetermined segment position P but has direct contact with an upper position Pc of the device pattern end portion Pb on the upper surface of the dicing tape 4 as illustrated in Fig. 6. The breaking bar 202 is further moved down a predetermined distance after the edge 202e comes in direct contact with the dicing tape 4 in the position Pc. That is to say, the breaking bar 202 is pressed into the substrate 10 at a predetermined pressing amount. The pressing amount preferably ranges from 0.05 mm to 0.2 mm (for example, 0.1 mm).

Then, a state of a three-point bending, in which the edge 202e of the breaking bar 202 is defined as a working point and an inner end portion f (fa, fb) of the mounted surface of each of the pair of unit holding parts 201a and 201b is defined as a supporting point, occurs. Accordingly, as indicated by arrows AR3 in Fig. 6, a tension stress acts on the substrate 10 in two opposite directions, and as a result, the vertical crack VC further extends, and the substrate 10 is once separated into two right and left portions and a space G is formed between the two portions.

Subsequently, when the breaking bar 202 is moved up and the pressing on the substrate 10 is released, the space G is closed and formed into a segmented surface D where the two right and left end portions are in direct contact with each other as illustrated in Fig. 7.

After the break process is finished, as indicted by arrows AR4 in Fig. 7, a tension stress is made to act on the dicing tape 4 in an in-plane direction, thus the dicing tape 4 extends, and the substrate 10 is separated into two portions 10A and 10B in the segmented surface D. Accordingly, the substrate 10 is segmented into the two portions.

### <Comparison with conventional method>

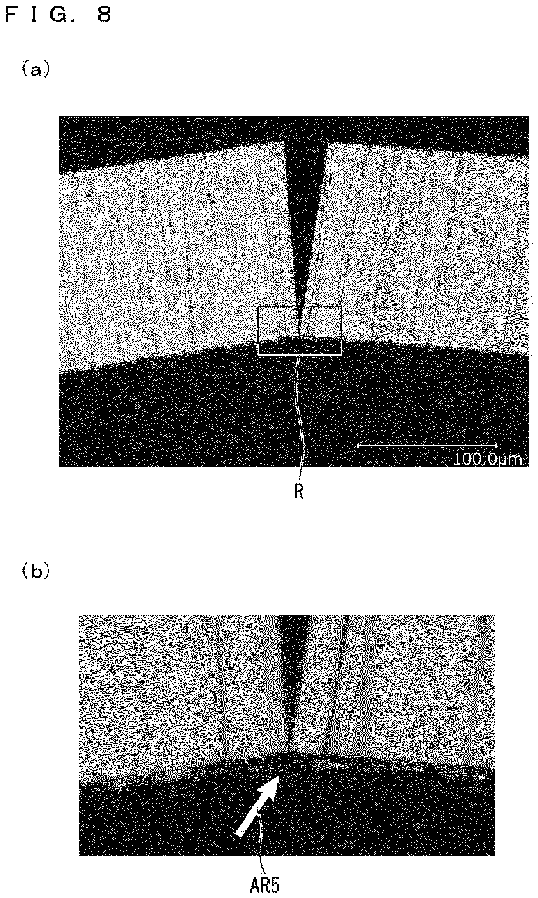

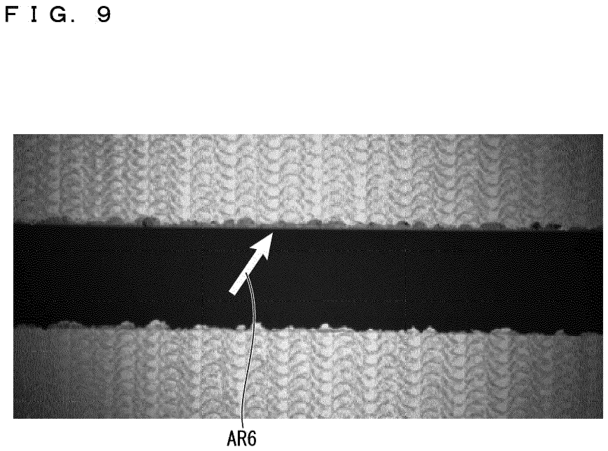

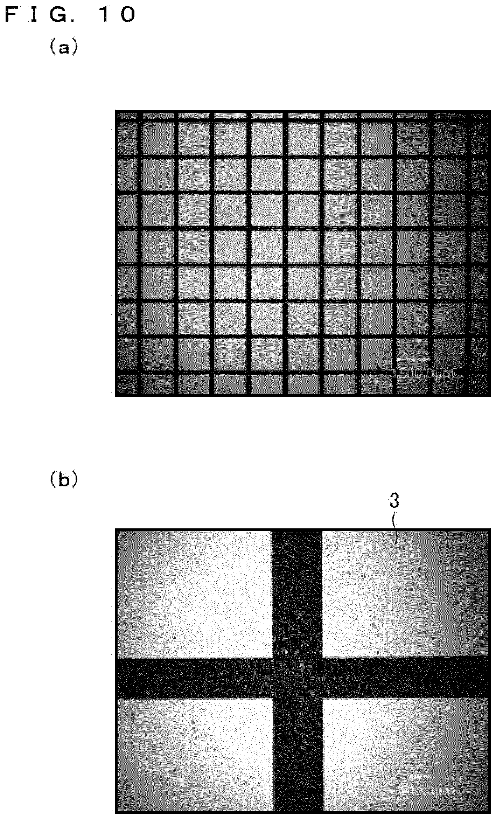

Fig. 8 and Fig. 9 are captured images each indicating a state of the substrate 10 on which a conventional segmenting process has been performed. More specifically, Fig. 8(a) is a captured image of a cross section in the substrate 10 before extension using the dicing tape, and Fig. 8(b) is an enlarged image of a portion R in Fig. 8(a). Fig. 9 is a captured image of the surface of the metal film 3 after the extension is performed. Fig. 10 is a captured image of the surface of the metal film 3 on a plurality of pieces obtained by segmenting the substrate 10 in a plurality of positions by a method according to the present embodiment.

Herein, the conventional segmenting process indicates that the scribe process and the break process are performed on the substrate 10 in a vertically reverse posture from that in the method according the present embodiment described above. That is to say, the scribe line is formed on the device pattern 2 side in the scribe process with the scribe device 100 and the breaking bar 202 is made to have direct contact with the metal film 3 in the break process.

In this case, as indicated by an arrow AR5 in Fig. 8(b), a portion where the metal film 3 is not segmented occurs after the break process. Even in a state where such a portion occurs, the metal film is segmented when the dicing tape 4 is extended. However, the peeling of the metal film 3 indicated by an arrow AR6 in Fig. 9 occurs in an end portion of the piece obtained by the division.

In contrast, when the method according to the present embodiment is applied, as illustrated in Fig. 10(a) and Fig. 10(b) which is the partial enlarged view of Fig. 10(a), the peeling of the metal film 3 illustrated in Fig. 9 is not confirmed after the division in the manner similar to the case where the scribe process described above is finished even though the division has been performed in a plurality of positions.

As described above, according to the present embodiment, the segmentation of the semiconductor device substrate in which the device pattern is formed on one main surface of the base material and the metal film is formed on the other main surface of the base material can be preferably performed without the occurrence of the peeling of the metal film, in the case where the segmentation is performed by the combination of the scribe process and the break process, by performing the break process after the metal film is previously segmented by the scribe process.

### <Modification example>

In the embodiment described above, the scribe process is performed using the scribing wheel, however, the scribe line may be formed using a tool, such as a diamond point, other than the scribing wheel as long as the formation of the scribe line and the extension of the crack are preferably achieved.

In the embodiment described above, at least the region in the stage 101 where the camera 103 takes an image needs to be made of the transparent material by reason that the positioning needs to be performed using the device pattern in the scribe device 100, however, if a predetermined alignment mark is formed in the metal film 3 and the positioning of the substrate 10 can be performed using the alignment mark by observation from above, the stage 101 needs not be made of the transparent material.

The break device used in the break process includes the holding part 201 made up of the pair of unit holding parts 201a and 201b separated from each other with the predetermined distance in the horizontal direction, however, a break device including a holding part made up of an elastic body having contact with the whole surface of the substrate and holding the substrate may also be used instead. The pressing amount in the break process preferably ranges from 0.05 mm to 0.2 mm (for example, 0.1 mm).

## Claims

1. A method of segmenting a substrate with a metal film, comprising:
a scribe step of scribing a predetermined segment position of a substrate with a metal film in a first main surface of the substrate on which a metal film is provided using a scribing tool to form a scribe line, thereby segmenting the metal film and extending a vertical crack from the scribe line along the predetermined segment position toward an inner side of the substrate with the metal film; and
a break step of making a breaking bar have direct contact with the substrate with the metal film from a side of a second main surface, on which the metal film is not provided, of the substrate with the metal film to further extend the vertical crack, thereby segmenting the substrate with the metal film in the predetermined segment position.

2. The method of segmenting the substrate with the metal film according to claim 1, wherein
the break step is performed in a state where the substrate with the metal film is in a vertically reverse posture from a case of the scribe step.

3. The method of segmenting the substrate with the metal film according to claim 1 or 2, wherein
the scribe step is performed in a scribe device,
the scribe device including:
a stage on which an object to be scribed is disposed; and
the scribing tool scribing the object to be scribed, which is disposed on the stage, from above in the scribe step, the substrate with the metal film is fixed to a stage in a posture where the first main surface faces the scribing tool.

4. The method of segmenting the substrate with the metal film according to claim 3, wherein
the scribe device further includes
a camera disposed below the stage to observe and take an image of the object to be scribed disposed on the stage, and
at least a region in the stage where the camera takes an image is made of a transparent material.
